## Europäisches Patentamt

(19) **European Patent Office**

**Office européen des brevets**

(11) Veröffentlichungsnummer: **0 071 311**

**B1**

(12) **EUROPÄISCHE PATENTSCHRIFT**

(45) Veröffentlichungstag der Patentschrift:
21.09.88

(51) Int. Cl.⁴: **G 06 K 19/06, H 01 L 23/48**

(21) Anmeldenummer: 82200936.1

(22) Anmeldetag: 22.07.82

(54) Verfahhren zur Herstellung von auf Anschlußflächen eines integrierten Bausteins aufgesetzten Kontaktelementen.

(30) Priorität: 31.07.81 DE 8122540 U

(43) Veröffentlichungstag der Anmeldung:
09.02.83 Patentblatt 83/6

(45) Bekanntmachung des Hinweises auf die Patenterteilung:
21.09.88 Patentblatt 88/38

(84) Benannte Vertragsstaaten:
DE FR GB IT NL

(56) Entgegenhaltungen:
DE-A-3 042 065
US-A-3 702 464
US-A-3 719 981

RCA TECHNICAL NOTES, TN No.: 1175, 16. Februar 1977, Seiten 1-2, Princeton, NJ, US; E. MYKIETYN et al.: "A compressible pillar for flip-chip thermocompression bonding"

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL- 5621 BA Eindhoven (NL)**

(84) Benannte Vertragsstaaten: **FR GB IT NL**

(72) Erfinder: **Funk, Walter, Galgenberg 24, D-2000 Wedel/Holst (DE)**
Erfinder: **Wijburg, Matheus Adrianus Theresias, Gerstweg 2, NL- 6534 AE Nijmegen (NL)**

(74) Vertreter: **Hartmann, Heinrich, Dipl.- Ing., Philips Patentverwaltung GmbH Wendenstrasse 35 Postfach 10 51 49, D-2000 Hamburg 1 (DE)**

## Beschreibung

### Verfahren zur Herstellung von auf Anschlußflächen eines integrierten Bausteins aufgesetzten Kontaktelementen

Die Erfindung bezieht sich auf ein Verfahren zur Herstellung von auf Anschlußflächen eines integrierten, insbesondere im Inneren einer Informationskarte anzuordnenden Bausteins aufgesetzten Kontaktelementen, welche zur Kontaktierung mit von einer Folie getragenen Leiterbahnen dienen und welche zunächst mit balliger Oberfläche hergestellt und dann auf gleiche Höhe abgeplattet werden.

Integrierte Bausteine mit aufgesetzten Kontaktelementen sind allgemein bekannt, beispielsweise aus dem Buch "Einführung in die Mikroelektronik" von Andreas Lewicki, R. Oldenburg-Verlag, München-Wien 1966, Seiten 290 - 294.

Die Kontaktelemente können dabei z. B. aus Kugeln einer Silberlegierung bestehen, die an die Anschlußflächen des integrierten Bausteins anlegiert sind. Sie können aber auch aus auf die Anschlußflächen aufgedampften Kontakten bestehen.

Integrierte Bausteine mit derartigen erhabenen Kontaktelementen besitzen den Vorteil, daß über diese nicht nur eine elektrische, sondern auch eine feste mechanische Verbindung des integrierten Bausteins mit den Leiterbahnen erfolgt. Zudem gestatten sie, die aus integriertem Baustein und Leiterbahnen bestehende Anordnung relativ flach zu gestalten.

Nachteilig ist allerdings, daß das Aufbringen der Kontaktelemente auf die Anschlußflächen des integrierten Bausteines relativ komplizierte und aufwendige Arbeitsvorgänge erfordert.

Wie aus der bereits genannten Literaturstelle auf Seite 286 ferner hervorgeht, können die Anschlußflächen eines integrierten Bausteins mit den Anschlußstellen von Leiterbahnen auch über Drähte nach dem sog. "Nagelkopf-Verfahren" verbunden sein. Eine derartige Kontaktierung ist relativ einfach herstellbar, besitzt jedoch den Nachteil, daß die aus integriertem Baustein und Leiterbahnen bestehende Anordnung eine verhältnismäßig große Bauhöhe besitzt.

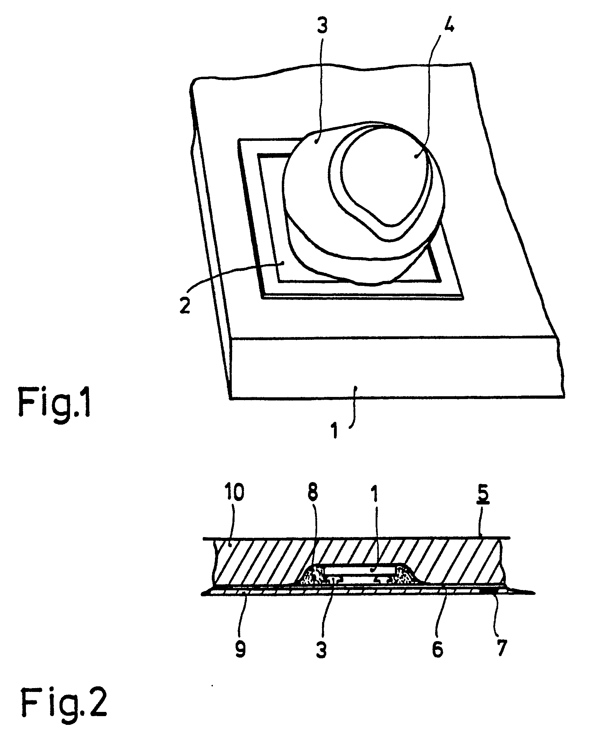

Wie aus der US-PS-3 702 464 hervorgeht, kommt es aber gerade bei aus integrierten Bausteinen und Leiterbahnen (bzw. Leiterbahnfolien) bestehende Anordnungen, die in das Innere von Informationskarten eingesetzt werden sollen, darauf an, deren Bauhöhe zu minimieren, da die Dicke einer Informationskarte nicht die genormte Größe von 0,670 mm übersteigen darf. Aus den Fig. 1 bis 3, insbesondere Fig. 2, geht dazu hervor, daß auch hier der integrierte Baustein mit erhabenen Kontaktelementen versehen ist. Über deren Herstellung bzw. Anbringen ist allerdings nichts weiter ausgeführt.

Ein Verfahren der eingangs genannten Art ist durch RCA Technical Notes, TH No. 1175, 16. Februar 1977, Seiten 1 - 2, Princeton, NJ, USA bekannt.

Der Erfindung liegt demgegenüber die Aufgabe zugrunde, die Herstellung und Anbringung der Kontaktelemente zu vereinfachen.

Diese Aufgabe wird gemäß der Erfindung dadurch gelöst, daß die einzelnen Kontaktelemente zunächst durch kugelförmiges Anschmelzen des Endes eines aus leitfähigem Werkstoff gebildeten Drahtes vorgeformt, dann unter hohem Preßdruck mit den Anschlußflächen verbunden und dabei auf eine vorgegebene Höhe abgeplattet sowie schließlich vom Draht getrennt werden.

Das Aufpressen der Drahtenden auf die Anschlußflächen eines integrierten Bausteins kann beispielsweise mit Hilfe des "Nagelkopf-Verfahrens" erfolgen. Nach Herstellung einer festen mechanischen Verbindung zwischen den Anschlußflächen und den Draht enden werden die Drähte von den Drahtenden getrennt, so daß ein integrierter Baustein mit erhabenen (aufgesetzten) Kontaktelementen vorliegt. Dieser integrierte Baustein kann dann nach dem sog. "flipchip"-Verfahren mit seinen Kontaktelementen auf bereits vorbereitete Anschlußstellen von Leiterbahnen gesetzt und mit diesen verlötet bzw. mittels eines leitfähigen Klebers verklebt werden.

Gegenüber den Kontaktelementen, die durch Legieren oder Aufdampfen auf die Anschlußflächen aufgebracht sind, können die Draht enden darstellenden Kontaktelemente erheblich einfacher mit den Anschlußflächen verbunden werden, was ggf. unter Einwirkung von zusätzlicher Wärme oder Ultraschall erfolgt. Hierdurch ergibt sich die Möglichkeit, daß beliebige, von verschiedenen Herstellern bereits auf dem Markt erhältliche integrierte Bausteine mit derart einfachen Kontaktelementen nachträglich versehen werden können.

Die aus mit derartigen Kontaktelementen versehenen integrierten Bausteinen und Leiterbahnen (bzw. Leiterbahnfolien) bestehenden Anordnungen weisen nur eine geringe Bauhöhe auf und eignen sich daher in besonderer Weise zum Einsatz in Informationskarten, z. B. Ausweis-, Scheck-, Zugangskontrollkarten etc.

Die Zeichnung stellt ein Ausführungsbeispiel der Erfindung dar.

Es zeigen:

Fig. 1 eine Ansicht auf ein Kontaktelement eines integrierten Bausteins, und

Fig. 2 eine schematischen Darstellung einer Informationskarte mit einem solchen integrierten Baustein.

In der Fig. 1 ist ein Randbereich eines integrierten Bausteins 1 dargestellt, auf dessen einer Seite sich eine Anschlußfläche 2 befindet, über die der integrierte Baustein 1 beispielsweise mit Information oder Energie versorgt wird. Auf diese Anschlußfläche 2 ist ein Kontaktelement 3 derart aufgesetzt, das es mit dem integrierten Baustein elektrisch und mechanisch fest verbunden ist. Das Kontaktelement 3 ist dadurch erzeugt, daß beispielsweise ein durch eine Kapillare geführter Golddraht an seinem Ende kugelförmig angeschmolzen wird, und daß dann mit Hilfe der Kapillare diese so erzeugte Kugel auf die Kontaktfläche 2 unter hohem Druck aufgepreßt wird, so daß eine feste mechanische Verbindung zwischen der Anschlußfläche 2 und dem Kontaktelement 3 zustandekommt. Die Verbindung kann unter Einwirkung von Wärme (Thermokompression) oder Ultraschall in ihrer Festigkeit ggf. weiter erhöht werden. Nach Herstellung der mechanischen Verbindung zwischen der Anschlußfläche 2 und dem Kontaktelement 3 wird der Golddraht von dem nunmehr deformierten Kontaktelement 3 getrennt, was beispielsweise durch Scherung mit Hilfe der Kapillare erfolgen kann. Die Kontaktelemente 3 sind ferner so ausgebildet, daß sie alle die gleiche Höhe besitzen. Hierdurch wird erreicht, daß sie in einfacher Weise mit Anschlußstellen von Leiterbahnen verbunden werden können, die auf einer ebenen Trägerfläche angeordnet sind.

Die Verbindung zwischen den Kontaktelementen 3 und den Anschlußstellen der Leiterbahnen kann z. B. mittels eines Metallotes oder mit Hilfe eines elektrisch leitfähigen Klebers erfolgen. Die Auflageflächen 4 der Kontaktelemente 3 können dazu derart mit einem leithähigen Kleber benetzt werden, indem sie kurzzeitig auf eine mit einer dünnen Klebeschicht bestrichenen, ebenen Platte gedrückt werden.

Selbstverständlich lassen sich zur Herstellung der Kontaktelemente auch Drähte aus einem anderen geeigneten, elektrisch leitfähigen Material verwenden.

In der Fig. 2 ist der Einsatz eines integrierten Bausteins 1 nach der Neuerung in einer Informationskarte 5, z. B. einer Ausweis-, Zugangskontroll-, Scheck-Karte etc., gezeigt. Dabei ist der integrierte Baustein 1 über seine Kontaktelemente 3 mit den Anschlußstellen von Leiterbahnen (nicht dargestellt) verbunden, die auf einer flexiblen Kunststofffolie 6 aufgebracht sind. Die Kunststofolie 6 kann z. B. beidseitig kupferkaschiert, durchmetallisiert und mit entsprechenden Kontakten 7 zur Außenwelt versehen sein. Die Kunststofolie 6 kann auch mehrlagig ausgeführt sein, sofern dies aus Systemgründen notwendig ist.

Zur Erhöhung der Festigkeit des integrierten Bausteins 1 auf der Kunststoffolie 6 ist dieser von einer isolierenden und aushärtenden Kunststoff- bzw. Vergußmasse 8 umhüllt. Die Kunststoffmasse 8 bzw. der integrierte Baustein 1 wird nach Aushärtung der Kunststoffmasse 8 so weit abgeschliffen, daß das System Kunststofolie 6 - integrierter Baustein 1 eine Gesamthöhe von ca. 350 μm besitzt.

Zur Bildung der Informationskarte 5 wird dieses System zwischen zwei weiteren Kunststoffolien 9 und 10 (z. B. PVC-Folien) eingepreßt. Dabei können die Form der Folien 9 und 10 sowie die Plazierung des integrierten Bausteins 1 so gewählt werden, daß die für Plastikkarten festgelegten Prägezonen freigehalten werden. Selbstverständlich können auch mehrere integrierte Bausteine 1 auf der flexiblen Folie 6 innerhalb der Informationskarte 5 untergebracht sein. Die Gesamtdicke der so erzeugten Karte 5 liegt bei ca. 0,760 cm. Ihre sonstigen Abmessungen können z. B. denjenigen der heute üblichen Scheck-Karten entsprechen.

## Patentansprüche

1. Verfahren zur Herstellung von auf Anschlußflächen eines integrierten, insbesondere im Inneren einer Informationskarte anzuordnenden Bausteins aufgesetzten Kontaktelementen, welche zur Kontaktierung mit von einer Folie getragenen Leiterbahnen dienen und welche zunächst mit balliger Oberfläche hergestellt und dann auf gleiche Höhe abgeplattet werden, dadurch gekennzeichnet, daß die einzelnen Kontaktelemente zunächst durch kugelförmiges Anschmelzen des Endes eines aus leitfähigem Werkstoff gebildeten Drahtes vorgeformt, dann unter hohem Preßdruck mit den Anschlußflächen verbunden und dabei auf eine vorgegebene Höhe abgeplattet sowie schließlich vom Draht getrennt werden.

2. Verfahren nach Anspruch 1, dadurch gekennzeichnet, daß die Kontaktelemente (3) zusätzlich unter Einwirkung von Wärme oder Ultraschall mit den Anschlußflächen (2) verbunden werden.

3. Verfahren nach Anspruch 1 oder 2, dadurch gekennzeichnet, daß die Drahtenden vom Draht durch Abscheren getrennt werden.

4. Verfahren nach einem der Ansprüche 1 bis 3, dadurch gekennzeichnet, daß die Kontaktelemente (3) und die Anschlußstellen (2) der Leiterbahnen durch einen leitfähigen Kleber oder durch ein Metallot miteinander verbunden werden.

5. Verfahren nach einem der Ansprüche 1 bis 4, dadurch gekennzeichnet, daß der mit den Anschlußstellen der Leiterbahnen verbundene integrierte Baustein (1) von einer Vergußmasse (8) umhüllt wird.

6. Verfahren nach Anspruch 5, dadurch gekennzeichnet, daß der umhüllte integrierte Baustein (1) auf eine gewünschte Bauhöhe abgeschliffen wird.

## Claims

1. A method of manufacturing contact elements provided on connection surfaces of an integrated circuit element to be arranged more particularly within an information card, which contact elements serve for contacting with conductor tracks carried by a foil and are first manufactured with a spherical surface and are then flattened to the same height, characterized in that the individual contact elements are first preformed by spherical melting of the end of a wire formed from a conductive material, are then connected to the connection surfaces under high pressure and flattened to a given height and are finally severed from the wire.

2. A method as claimed in Claim 1, characterized in that the contact elements (3) are additionally connected with the use of heat or ultrasonic waves to the connection surfaces (2).

3. A method as claimed in Claim 1 or 2, characterized in that the wire ends are severed from the wire by shearing.

4. A method as claimed in any one of Claims 1 to 3, characterized in that the contact elements (3) and the connection areas (2) of the conductor tracks are interconnected by a conductive glue or by a metal solder.

5. A method as claimed in any one of Claims 1 to 4, characterized in that the integrated circuit element (1) connected to the connection area of the conductor tracks is enveloped by a moulded mass (8).

6. A method as claimed in Claim 5, characterized in that the enveloped integrated circuit element (1) is ground to a desired constructional height.

**Revendications**

1. Procédé pour la réalisation d'éléments de contact montés sur les surfaces de connexion d'un composant intégré a disposer notamment à l'intérieur d'une carte d'information, éléments de contact qui servent au contact avec des trajets conducteurs supportés par une feuille et qui sont réalisés d'abord de façon à présenter une surface bombée pour être aplatis ensuite à la même hauteur, caractérisé en ce que les éléments de contact séparés sont d'abord formés par fusion en forme d'une boule de l'extrémité d'un fil constitué par de la matière conductrice, après quoi ils sont reliés sous une pression élevée aux faces de connexion et ensuite aplatis a une hauteur préalablement déterminée et finalement séparés du fil.

2. Procédé selon la revendication 1, caractérisé en ce que les éléments de contact (3) sont reliés en outre par effet de chaleur ou par ultrasons aux faces de connexion (2).

3. Procédé selon la revendication 1 ou 2, caractérisé en ce que les extrémités de fil sont séparées du fil par cisaillement.

4. Procédé selon l'une des revendications 1 à 3, caractérisé en ce que les éléments de contact (3) et les emplacements (2) des conducteurs sont reliés par une colle conductrice ou par soudure entre eux.

5. Procédé selon l'une des revendications 1 à 4, caractérisé en ce que le composant intégré (1) relié aux endroits de connexion des conducteurs est enveloppé d'une masse de remplissage (8).

6. Procédé selon la revendication 5, caractérisé en ce que le composant intégré enveloppé (1) est meulé de façon à obtenir la hauteur de construction désirée.

Fig.1

Fig.2